# EUROPEAN PATENT APPLICATION

(11) **EP 1 113 354 A2**
(43) Date of publication of application: **04.07.2001**
(21) Application number: 00401580.6
(22) Date of filing: 06.06.2000
(51) Int. Cl.: G06F 1/16

(54) **Bilateral monitor**

(30) Priority: 17.12.1999 KR 9928606
(71) Applicant: Global Networks Systems Co., Ltd., Seocho-Gu, Seoul (KR)
(72) Inventor: Rhee, Young-Kook, Anyang-City, Kyungki-Do (KR)
(74) Representative: Schrimpf, Robert

(57) **Abstract**

A bilateral monitor adapted to show data from a computer body on two screens, the monitor comprising: two hinged base members, each for swing at a mutually predetermined angle on a horizontal surface; and such that the base members can be folded to thereby reduce volume thereof for easy carry of the monitor, and are freely unfolded and folded on an upper surface of an installation pad thereof to allow an adjustable angle for free and stable installation of the monitor.

## Description

### BACKGROUND OF THE INVENTION

### FIELD OF THE INVENTION

The present invention relates to a monitor, and more particularly to a bilateral monitor for computer.

### DESCRIPTION OF THE PRIOR ART

A computer monitor, a computer component having a screen for allowing a user to know of a picture signal coming from a body, includes a screen part and a control part for controlling a screen at the screen part, and is coupled to an upper side of a base.

A bilateral monitor has been recently developed having two screens to allow two persons or one person to work looking at a different screen. The bilateral monitor is so constructed as to be installed on both sides of a base member with two monitor plates, where the monitor plates are rotated or tilted for adjustment at a predetermined angle good and easy for a user to look at.

However, there is a problem the bilateral monitor according to the prior art having two monitor plates installed at one base member thus described in that the base is broad such that even if the monitor plate is folded, the plate is still voluminous, making it difficult for the monitor to be carried.

Still worse, there is another problem in that an installment pad on which the monitor is placed is narrow, or the broad base member is cumbersome where various stuffs are arranged together at surroundings thereof such that the monitor cannot be effectively laid out.

### SUMMARY OF THE INVENTION

The present invention is disclosed to solve the aforementioned problems and it is an object of the present invention to provide a bilateral monitor adapted to fold a base member to thereby reduce volume for easy carry and installment thereof.

In accordance with the object of the present invention, there is provided a bilateral monitor adapted to show data from a computer body on two screens, the monitor comprising:
two hinged base members, each for swing at a mutually predetermined angle on a horizontal surface; and
monitor plates, each coupled to the base member, where each monitor plate is so pivoted as to be freely tilted on the base member and each monitor plate may be so hinged to the base member so as to be tilted only to left and right directions.

### BRIEF DESCRIPTION OF THE DRAWINGS

For fuller understanding of the nature and objects of the invention, reference should be made to the following detailed description taken in conjunction with the accompanying drawings in which:
Figure 1 is a perspective view of a bilateral monitor taken from front side thereof according to a first embodiment of the present invention;

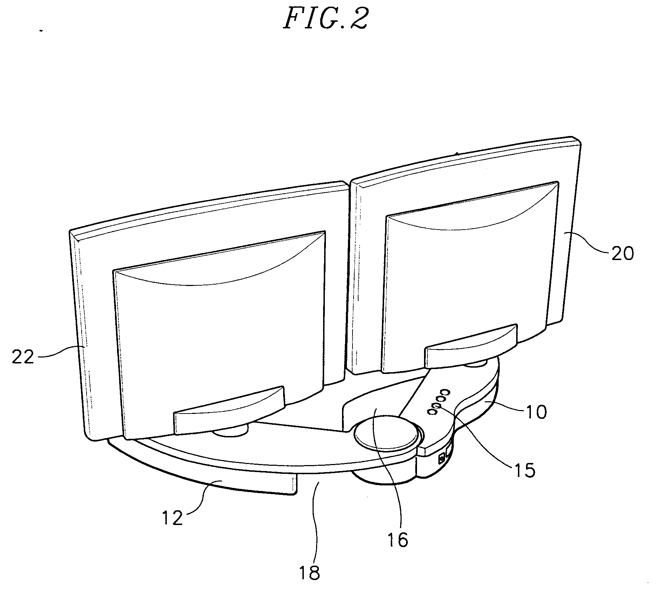

Figure 2 is a perspective view of a bilateral monitor taken from rear side thereof according to the first embodiment of the present invention;

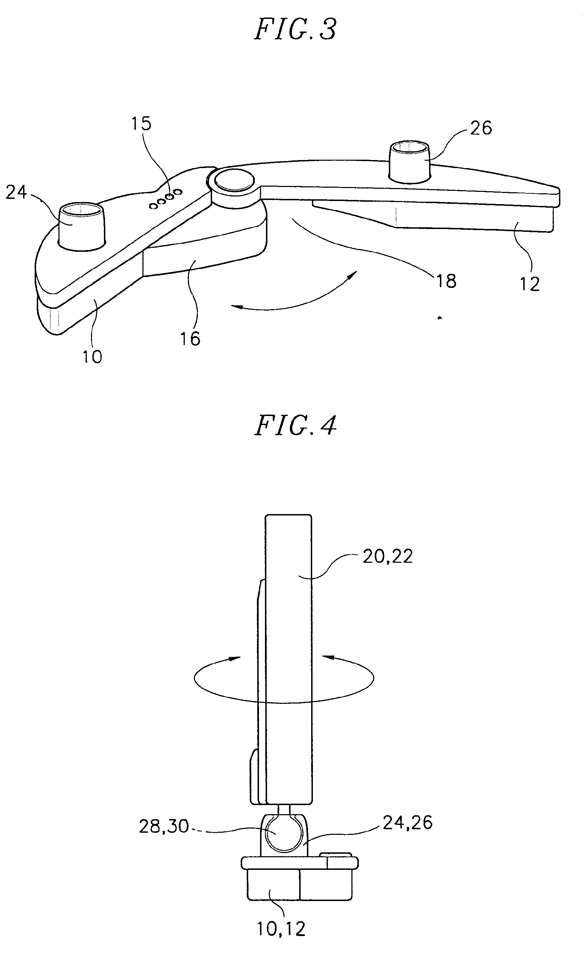

Figure 3 is a perspective view of a bilateral monitor where base members are coupled according to the first embodiment of the present invention;
Figure 4 is a schematic diagram of a monitor plate coupled to a base member of the bilateral monitor according to the first embodiment of the present invention;
Figure 5 is a schematic diagram of a monitor plate coupled to a base member of a bilateral monitor according to a second embodiment of the present invention; and
Figure 6 is a sectional view of hinge coupling part at both base members of a bilateral monitor according to the present invention.

### DETAILED DESCRIPTION OF THE INVENTION

Now, preferred embodiments of the present invention will be described in detail with reference to the accompanying drawings.

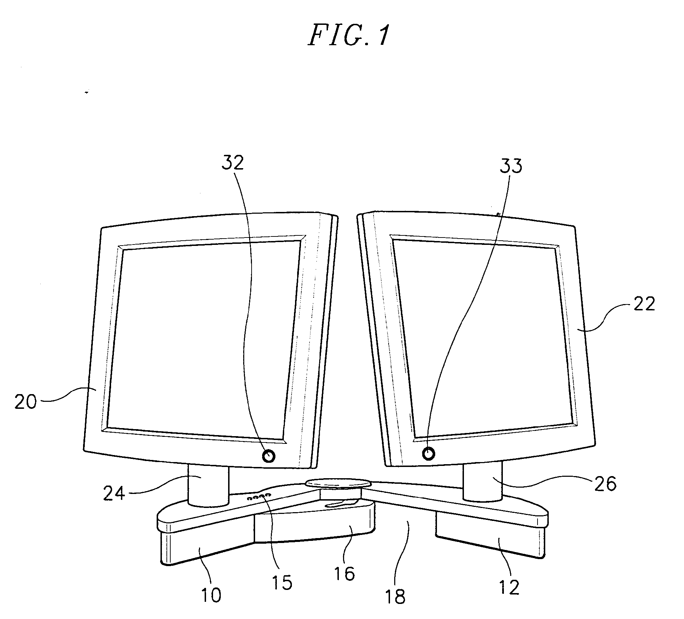

As illustrated in Figure 1, two base members 10 and 12 are hinged each other so as to swing each at a predetermined angle on a horizontal surface, and are installed thereon with monitor plates 20 and 22 each having a liquid crystal screen.

Each base member 10 and 12 is formed of long narrow crescent shape, where the base member 10 is coupled at one side thereof to a plurality of manipulating switches 15 and is formed at a hinge coupling part thereof with a protruder 16 for the facing base member 12 to be inserted when folded. The base member 12 is formed at the hinge coupling part thereof with a receptible part 18 for encompassing the protruder 16.

The base members 10 and 12 are formed thereon with protruders 24 and 26 each having a receptible groove for bottom surfaces of the monitor plates 20 and 22 to be inserted thereinto.

As illustrated in Figure 4, the monitor plates 20 and 22 are formed thereunder with ball parts 28 and 30 for being inserted into the receptible groove of the protruders 24 and 26 to thereby be pivot-coupled. In other words, the monitor plates 20 and 22 are pivot-coupled to be freely tilted on the base members 10 and 12.

Accordingly, each monitor plate 20 and 22 can be rotated at a predetermined angle on the base members 10 and 12 and tilted at a predetermined angle on the horizontal surface as shown in Figure 4. The monitor plates 20 and 22 may be hinge-coupled to the base members 10 and 12 so as to be tilted to the left and right directions or rotated on the horizontal surface. The base members 10 and 12 are disposed with wirings (not shown) and the monitor plates 20 and 22 are mounted thereunder with monitor switches 32 and 33.

Although the monitor plates 20 and 22 are tilted to the left and right directions, the plates 20 and 22 may be hinge-coupled to the base members 10 and 12.

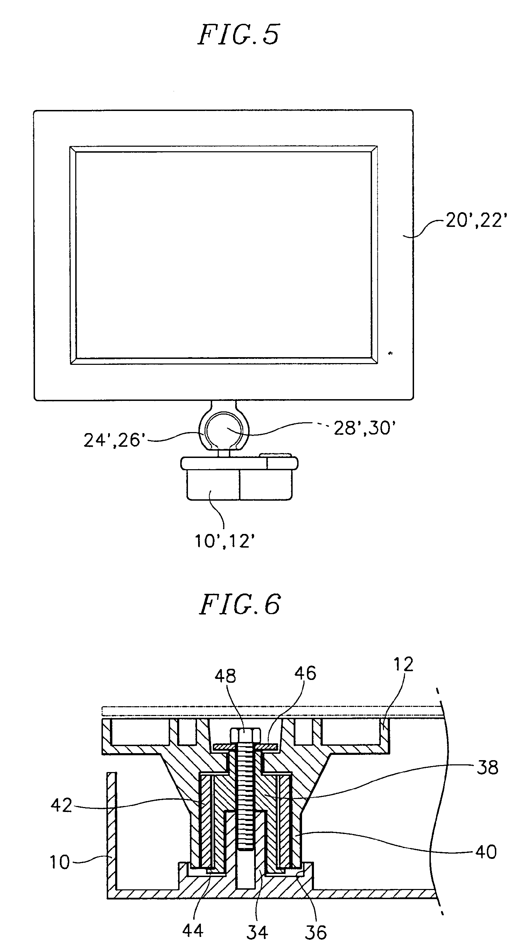

As shown in Figure 5, base members 10' and 12' may be formed with ball parts 28' and 30', and receptible parts 24' and 26' for accommodating the ball parts 28' and 30' may be formed at monitor plates 20' and 22'.

Furthermore, the monitor plates 20' and 22' may be coupled at each rear surface thereof to a control board for controlling a screen part, and the base members 10' and 12' may be arranged therein with power supply apparatus (not shown) such as adapter and the like.

Figure 6 is a hinge coupling part of the base members 10 and 12. As illustrated in Figure 6, the base member 10 is formed at one side thereof with a protruder 34 formed with a screw hole. The protruder 34 is provided at root thereof with groove 36 along the peripheral direction. A bush 38 is formed between the protruder 34 and the groove 36.

The base member 12 is formed at the other side thereof with a tip end of a protruder 40 having a hole for receiving the bush 38 for the groove 36 to slip into, and the protruder 40 is inserted by a bearing 42 to slip at the bush 38.

The bush 38 is formed at a lower end thereof with a hitching jaw 44 to thereby be hitched at the bearing 42. The protruder 34 and the bush 38 are fixed by a bolt via a washer 46.

In the bilateral monitor thus constructed, the monitor plates 20 and 22 are respectively mounted on the hinge-coupled base members 10 and 12, such that, when the base members 10 and 12 are folded, volume thereof is reduced for easy carry of the monitor. Furthermore, an installation pad on which the monitor is placed becomes narrower, and the base members 10 and 12 get narrower to allow various articles to be effectively laid at surroundings thereof.

It should be apparent that although the present invention has been disclosed in the foregoing, embodiments, other variations can be added without departing from the scope of the present invention as defined in the appended claims.

As apparent from the foregoing, there are advantage in the bilateral monitor according to the present invention thus described in that the base members can be folded to thereby reduce volume thereof for easy carry of the monitor, and are freely unfolded and folded on an upper surface of an installation pad thereof to allow an adjustable angle for free and stable installation of the monitor.

## Claims

1. A bilateral monitor adapted to show data from a computer body on two screens, the monitor comprising:
two hinged base members, each for swing at a mutually predetermined angle on a horizontal surface; and
monitor plates, each coupled to the base member.

2. The monitor as defined in claim 1, wherein each monitor plate is so pivoted as to be freely tilted on the base member.

3. The monitor as defined in claim 1, wherein each monitor plate is so hinged to the base member so as to be tilted to left and right directions.
